(19) Europäisches Patentamt
European Patent Office
Office européen des brevets

(11) **EP 2 806 563 A1**

(12) **EUROPEAN PATENT APPLICATION**

(43) Date of publication:
**26.11.2014 Bulletin 2014/48**

(51) Int Cl.:
***H03L 7/197*** *(2006.01)*

(21) Application number: **13305655.6**

(22) Date of filing: **22.05.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Asahi Kasei Microdevices Corporation Tokyo 101-8101 (JP)**

(72) Inventor: **Charpentier, Sebastien 14460 Colombelles (FR)**

(74) Representative: **Cabinet Plasseraud 52, rue de la Victoire 75440 Paris Cedex 09 (FR)**

(54) **Phase lock detection in fractional-Q digital PLL**

(57)     There is disclosed a phase error detection scheme for detecting a phase lock state of a fractional Digital Phase-Locked Loop, DPLL, circuit (1), applicable to DPLL structures using modulation of the fractional portion of a frequency divider ratio. The proposed scheme relies on observing the digital phase error signal at the output from a modulation noise cancellation module. Since the phase error message after the modulation noise cancellation module does not depend on fractional modulation, a very high precision of the phase lock detector can be achieved.

**FIG.4**

## Description

## BACKGROUND

**Technical Field**

The present invention generally relates to devices and methods for phase lock detection in Digital Phase-Lock-Loops (DPLL) structures, and more particularly in fractional-Q DPLL structures.

**Related Art**

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

DPLL are used to generate an output signal with a high frequency *Fout,* for instance a Radiofrequency (RF) output signal, from a reference clock signal of lower, stable frequency *Fref.* DPLLs have superseded classical, i.e., analog Phase-Lock-Loops (PLL) in performances and design simplicity, and are therefore used in an increasing number of applications. For instance, DPLLs are used in frequency synthesizers for cellular phones or smart phones, digital tablets, digital Tv decoders, Wifi detection modules in desktop computers, etc.

DPLL structures are composed of several blocks or modules, including a Time-to-Digital Converter (TDC), a digital loop filter, a Digital-to-Analog Converter (DAC), a Voltage Controlled Oscillator (VCO) or a Digitally Controlled Oscillator (DCO) or DVCO (Oscillator with a digital and an analog inputs), a frequency divider adapted to generate a divided clock signal from the output signal, etc.

Some DPLL architectures may require a lock detect signal. In some applications, indeed, such lock detect signal may be used for triggering internal calibrations processes. Also, a frequency synthesizer including the DPLL may output such a lock detect signal, for example through a dedicated output pad, for the purpose of being used by the RF system.

Most lock detectors currently known for classical, i.e., analog PLL are based on a capture window mechanism implemented at the input of the Phase/Frequency Detector (PFD) of the analog PLL. The PFD is adapted to generate an output pulse whose duration depends on the time difference between edges of the reference clock and respective edges of the so-called "divided clock" issued by the frequency divider arranged in the return path of the PLL. This pulse is adapted to drive the Charge Pump (CP) of the PLL.

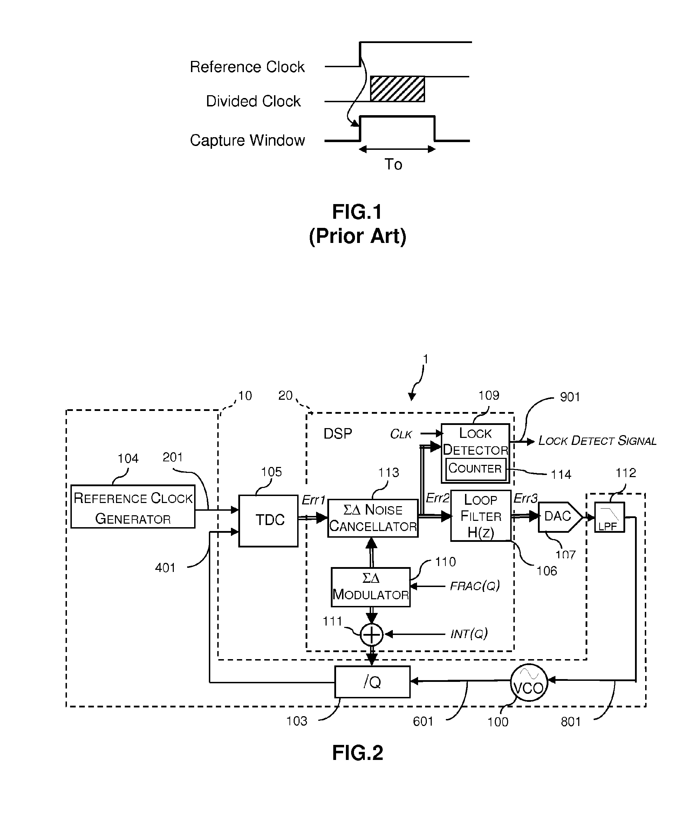

With reference to **FIG.1,** the lock condition of such analog PLL is met when an active edge of the divided clock lies within a capture time window of fixed duration, which is triggered by an active edge of the reference clock during a certain amount of time. A digital counter may be used for measuring said amount of time.

However, due to the fractional modulation which is implemented in fractional-Q PLL structures, this implementation is not very accurate. Indeed the edges of the divided clock suffer from jitter due to the fractional modulation performed for obtaining a non integral division factor Q in the frequency divider. It results there from that the capture window length must be relatively large, typically in the range of 5 to 10 nanoseconds (ns). In addition, most of the time the capture window depends on analog design parameters which are highly sensitive to Process/Voltage/Temperature (PVT) variations.

Two types of DPLL structure currently exist: non-fractional DPLL and fractional DPLL. In the former structure, the division ratio of the frequency divider is an integral number *N*. In the latter structure, the division ratio of the frequency divider is a non-integral number *Q*, which may be split in and integral portion *int(Q)* and a fractional portion *frac(Q),* so that :

$$Q = INT(Q) + FRAC(Q) \tag{1}$$

For instance, for generating a synthesized signal with a frequency equal to *QxFref,* a fractional DPLL may use a Sigma-Delta ($\Sigma\Delta$) Modulator for modulating a digital value corresponding to the fractional portion *frac(Q)* of the divider ratio *Q* of the frequency divider, which can thus be summed to the integral portion *int(Q)* of said divider ratio *Q*.

A DPLL is characterised by its operating frequency and by its ability to promptly and efficiently lock to the desired frequency for the synthesized signal. Whether this condition is met or not may be determined by a lock detector module. A lock detector module is adapted to receive a phase error value provided by the TDC from comparing mutual phases of the reference signal and the synthesized signal, and to output an indication that a lock condition is met or not, with respect to this phase error value.

US Patent No. 8,248,106 discloses a TDC based Frequency Lock Detector (TFLD) in a divider-less fractional-N DPLL structure requiring no divider modulation, which is presented as an alternative to conventional counter based lock detect circuits. The frequency lock detector accepts a digital phase error message *PHERR* and a unit-less frequency error tolerance Δ*F*. The frequency lock detector is designed to generate periodically a lock detect signal indicating whether a synthesizer clock frequency is within the frequency error tolerance value of a reference clock frequency. However determination of the lock condition is not easy, since the frequency error tolerance value Δ*F* value depends on the value of VCO frequency, being calculated as follows:

$$\Delta F = (Fvco – Ftarget) / (Ftarget) \qquad\qquad (2)$$

where: *Fvco* is the frequency of the output signal of the VCO; and,
*Ftarget* is the desired frequency of the synthesized signal.

The determination of the frequency of the VCO in many devices is not easy. Indeed, the value of the VCO frequency changes quickly responsive to its input signal. Further, the frequency lock detector as taught by US Patent No. 8,248,106 performs a frequency lock detection instead of a phase lock detection. Finally, the proposed implementation operates in a divider-less fractional-N DPLL requiring no divider modulation.

Thus, there is still a need for a simple detection scheme for detecting a phase lock condition of a fractional-Q DPLL relying on frequency divider modulation.

## SUMMARY

To present invention aims at providing accurate phase lock detection in a DPLL.

According to embodiments, it is proposed to observe the phase error signal after the ΣΔ noise cancellation module, then count the number of clock periods wherein the phase error signal is below a threshold value. Since the phase error signal after the ΣΔ noise cancellation module does not depend on fractional modulation, the threshold value can be very low. Thus, a very high precision of the lock detector is achieved. The precision of the phase lock detector depends on the TDC resolution, but in all cases it is more accurate than lock detectors used in a classic (i.e. analog) fractional-Q PLL.

More, precisely, a first aspect of the invention relates to a fractional Digital Phase-Locked Loop, DPLL, circuit comprising:

- an Oscillator, adapted to generate a synthesized clock signal;

- a fractional frequency divider, adapted to divide the synthesized clock signal by a division ratio having an integer part and a fractional part,

- a Time-to-Digital Converter, TDC, having:

  ■ a first input adapted to receive a reference clock signal,

  ■ a second input adapted to receive the divided synthesized clock signal from the fractional frequency divider,

  ■ an output adapted to generate a first phase error message representative of a phase error between the reference clock signal and the divided synthesized clock signal and including ΣΔ noise,

- a digital modulation module adapted to generate a modulation signal and to modulate the fractional part of the division ratio using said modulation signal,

- a digital modulation noise cancellation module having:

  ■ a first input adapted to receive the first phase error message from the TDC,

  ■ a second input adapted to receive the modulation noise from the modulation module,

  ■ an output adapted to generate a second digital phase error message corresponding to the first phase error message in which a modulation noise associated to the modulation of the fractional part of the division ratio has been cancelled,

- a digital phase lock detector module having an input adapted to receive the second phase error signal and to generate a lock detect signal indicating a lock state of the DPLL, with respect to the second phase error message.

A second aspect relates to a method of detecting a phase lock state of a fractional Digital Phase-Locked Loop, DPLL, circuit as defined above with respect to the first aspect, wherein the method comprises generating a lock detect signal indicating the lock state of the DPLL, with respect to the second phase error message.

Embodiments are applicable to DPLL structures using modulation of the fractional portion *frac(Q)* of the frequency divider ratio *Q*. The proposed phase lock detection scheme thus relies on observing the digital phase error signal at the output the modulation noise cancellation module. Moreover, a method using a threshold value compared to digital phase error values will be implemented to enhance the reliability of the detection of the phase lock condition.

Since the (second) phase error message after the modulation noise cancellation module does not depend on fractional modulation, a very high precision of the phase lock detector can be achieved. The precision of the phase lock detector depends on the TDC resolution. In all cases, the phase lock detector is more accurate than lock detectors used in a classic (i.e. analog) fractional-Q PLL as known in the prior art.

In some embodiments of the DPLL circuit and of the method, the lock detect signal is activated when a given number of successive values of the second phase error messages keep below a given threshold.

The given number and/or the given threshold may be programmable.

A third aspect relates to a frequency synthesizer integrated circuit comprising a fractional Digital Phase-Locked Loop, DPLL, circuit according to the first aspect.

Finally, a fourth aspect relates to a computer program product comprising one or more stored sequences of instructions that are accessible to a processor and which, when executed by the processor, cause the processor to perform the steps of a method according to the second aspect.

**BRIEF DESCRIPTION OF THE DRAWINGS**

Embodiments of the present invention are illustrated by way of example, and not by way of limitation, in the figures of the accompanying drawings, in which like reference numerals refer to similar elements and in which:

- FIG.1, already described, illustrates the capture window mechanism used in analog PLL of the prior art;

- FIG.2 is a simplified block diagram of a DPLL circuit according to proposed embodiments;

- FIG 3 shows curves, as a function of time, of the phase error signal before and after fractional modulation noise compensation as implemented in the DPLL circuit of FIG.2 when the PLL is in lock condition; and,

- FIG.4 shows timing diagrams illustrating an example of operation of the phase error detector which may be used in the DPLL circuit of FIG.2.

**DESCRIPTION OF EMBODIMENTS**

Embodiments as described herein are directed to a phase lock detecting scheme which is applicable to DPLL structures using modulation of the fractional portion *frac(Q)* of the frequency divider ratio, as explicated in the introduction.

The proposed phase lock detection scheme uses the digital error phase signal directly from a divider modulation noise cancellation module, for instance a $\Delta\Sigma$ noise cancellation module where the divider modulation uses a $\Delta\Sigma$ modulator.

As will be described in further details below, a method of actually detecting the phase lock condition may use a counter and a comparator to compare the digital error phase values with a threshold value.

In the description which follows and in the accompanying drawings, it will be assumed that active edges of any logic signal, in particular of the DPLL clock signals, are rising edges. The one with ordinary skills in the art knows, however, that other implementation choices are possible depending on the specific application.

Referring to **FIG.2,** there is shown therein a simplified block diagram of a fractional-Q DPLL circuit 1, to which embodiments of the invention can be applied. In the shown example, circuit 1 is implemented as part of a mixed, i.e. analog and digital, Integrated Circuit (IC), for instance a fractional DPLL-based frequency synthesizer.

The shown fractional-Q DPLL can thus be divided into three parts depending on the nature, i.e. analog and/or digital, of the signals processed therein. A first part 10 comprises elements which are typically realized in the analog domain. A second part 20 may comprise blocks which are implemented in the digital domain, for instance in the form of hardware modules and/or software modules of an application software running on a Digital Signal Processor (DSP). Finally, mixed analog-digital elements comprise devices adapted to perform conversion of signals from the analog part 10 to the digital 20 or *vice versa,* for instance a Time-to-Digital Converter (TDC) 105 and a Digital-to-Analog Converter (DAC) 107, respectively.

The first part 10 is composed of analog elements receiving and/or outputting analog signals. In the shown DPLL structure, these components comprise:

- an Oscillator 100, which is adapted to receive an analog frequency tuning voltage 801, and to generate a synthesized clock signal 601 at the desired high frequency, namely the output signal of the DPLL;

- an analog Low-Pass Filter (LPF) 112, adapted to filter an analog signal *Err3* received from the output of the Digital-to-Analog Converter 107, and to generate the analog frequency tuning voltage 801 for controlling the oscillator 100. Filter 112 is optional, but it helps removing the quantization effects introduced by the digital processing and DAC clock feedthrough. In some embodiments, filter 112 may be a simple, passive analog filter,

- a frequency divider 103, adapted to generate a divided version of the synthesized signal 601, referred to in what follows as the divided clock signal 401; and,

- a reference clock generator 104, which is adapted to provide a reference clock signal 201 of fixed and stable frequency *Fref*. Generator 104 may be, for instance, a crystal oscillator.

The frequency of the synthesized signal 601 is programmable and is controlled by setting the division ratio *Q* of the frequency divider 103 at a desired number, which may be integral or no-integral, i.e., fractional. In embodiments as shown, the frequency divider is a fractional-Q divider, where Q is a non-integral division ratio which can be split into an integral part *INT(Q)* and a fractional part *FRAC(Q)* as defined by relation (1) given in the introduction

The TDC 105 has a first input for receiving the reference clock signal 201, and a second input for receiving the divided clock signal 401 from the frequency divider 103. It is adapted to measure the time difference between respective active edges of the signals received on its two inputs, and to generate digital words which in sequence form a phase error message *Err1* representative of the phase offset between said signals.

It will be appreciated by the one skilled in the art that he TDC has the same function as the PFD + Charge Pump of an analog PLL as described in the introduction. Hence, the synthesized signal 601 has a frequency equal to *Q* times the frequency of the reference clock signal 201. The digital word coming out from the TDC is a digital "image" of the charge quantity generated by an analog Charge Pump.

The loop feedback signal, namely the divided clock signal 401 contains the fractional modulation noise inserted at the frequency divider 103 as part of the process of dividing frequency of the synthesized clock signal 601. It follows there from that the digital message *Err1* carries the modulation noise signal in addition to the phase error information, the latter being the information of interest.

The second part 20 of the DPLL circuit 1 comprises digital blocks receiving and/or outputting digital signals, which can be software and/or hardware implemented functions running within a DSP. In the shown DPLL circuit, these blocks comprise:

- a modulation module, for instance a Sigma-Delta modulation module (ΣΔ modulator) 110, which is adapted to generate a modulation signal in higher bands of the frequency spectrum and to use it for modulating the fractional part *FRAC(Q)* of the division ratio *Q* of the frequency divider 103;

- a Sigma-Delta noise cancellation module (ΣΔ noise cancellor) 113 adapted to remove the fractional modulation noise from the phase error message *Err1* output by the TDC 105. To that end, the ΣΔ noise cancellor 113 is coupled to the ΣΔ modulator 110 in order to operate with respect to the modulation signal as applied. It delivers a phase error message *Err2* corresponding to the phase error message *Err1* of which the fractional modulation noise has been removed;

- a digital loop filtering module (loop filter) 106 adapted to receive the fractional modulation noise filtered message *Err2* output by the ΣΔ noise cancellor 12 and to output a loop filtered version *Err3* thereof. Said digital message *Err3* is then digital-to-analog converted by the DAC 107, and, optionally after additional low-pass filtering by the analog filter 112, gives the analog frequency tuning voltage 801 for controlling the oscillator 100; and,

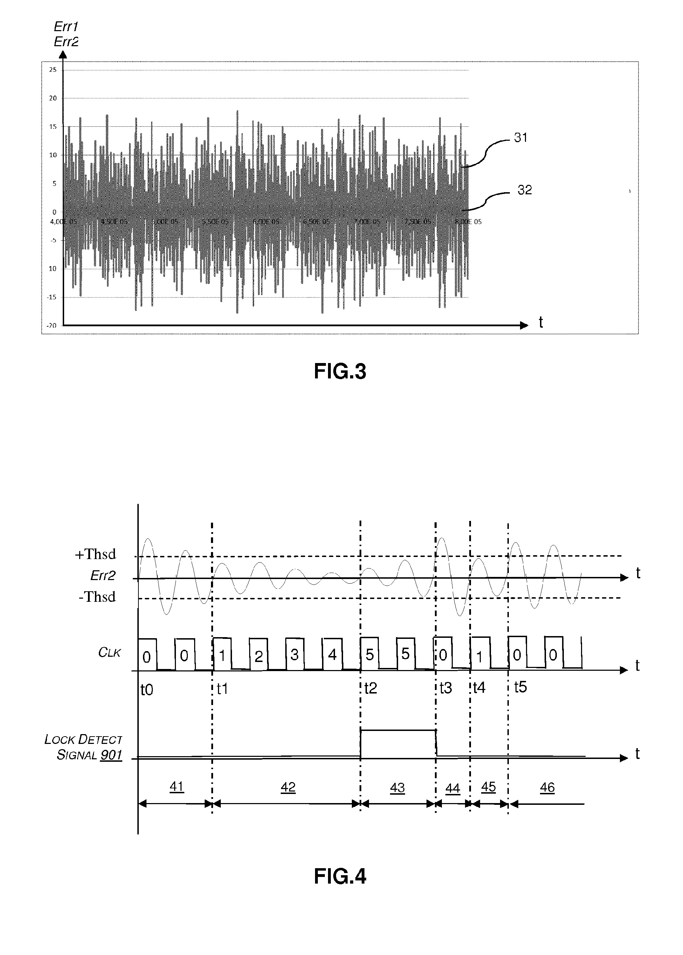

- a lock detector module 109 of which the operation will be explicated below with reference to FIG.4.

It will be appreciated that any type of digital calculator such as, for instance, a FPGA (Field Programmable Gate Array) circuit, can be used instead of a DSP.

The loop filter 106 is operable to filter the phase error message *Err2* using well-known mathematical functions implementing a loop filter transfer function H(z).

The message *Err3* thus obtained at the output of the loop filter 106 is sent to an input of a digital-analog converter 107.

The operating principle of the ΣΔ modulator 110 is well known by the one skilled in the art, and describing details of such operation would go beyond the scope of the present disclosure. In some embodiments, the frequency of the modulation signal is programmable, so the circuit may be used for various applications, and for a wide range of frequency of the synthesized signal 601.

The ΣΔ noise canceller 113 uses mathematical functions with complex algorithms to achieve removal of the ΣΔ modulation noise introduced by the ΣΔ modulator 110 and thus generate the phase error message *Err2* representing only the phase error information with respect to the reference clock signal 201 and the divided clock signal 401. Stated otherwise, the second digital phase error message *Err2* corresponds to the first phase error message *Err1* in which the modulation noise associated to the modulation of the fractional part of the division ratio has been cancelled.

Only this fractional modulation noise free phase error message *Err2* is passed to the loop filter 106 in the shown example. According to teachings of the present disclosure, further, this fractional modulation noise free phase error message *Err2* is input to the phase lock detector 109.

The phase lock detector 109 includes at least one input for receiving the phase error message *Err2* output from the ΣΔ noise cancellator 113, and has at least one output adapted to output a lock detect signal 901. Detector 109 further receives an operational clock signal *Clk*, which may be derived from the reference clock signal 201 so as to have the same frequency as the update frequency of the TDC 105.

As shown in **FIG.3,** in which message *Err1* before ΣΔ noise cancellation is represented by curve 31 and message *Err2* after ΣΔ noise cancellation is represented by curve 32, the swing of the phase error is much smaller after compensation of the effects of the fractional-Q modulation. Hence, counting the number of clock periods wherein a small phase error characterizes a phase lock condition, may rely on a threshold value which can be can very low.

According to embodiments, indeed, it is proposed to observe the phase error values of the digital message *Err2* after ΣΔ noise cancellation, then count the number of periods of the clock signal *Clk* in which the phase error is below a threshold value.

Using the phase error signal for the lock detection, knowing that the said phase error signal is the result of the integration of the frequency signal between the two input signals of the TDC module, enables to obtain better performances for the lock detection. Moreover, since the phase error signal after the ΣΔ noise cancellation module does not depend on fractional modulation, a very high precision of the phase lock detector can be achieved. The precision of the phase lock detector depends on the TDC resolution. TDC resolution is typically in the order of 20 picoseconds (ps), and thus setting the phase lock condition at a number K of periods of the clock signal during which the phase error values must be under the threshold results in a phase lock detector precision of Kx20 ps. In all cases, the phase lock detector is more accurate than lock detectors used in a classic (i.e. analog) fractional-Q PLL as known in the prior art.

A method of generating the lock detect signal 901 is further proposed herein, and will now be described with reference to the timing diagrams of **FIG.4.** For the sake of better understanding a linear curve is shown at top of this figure, which corresponds to a phase error analog signal would result from an interpolation of the discrete phase error values of the digital phase error message *Err2,* or from a digital-to-analog conversion thereof. It will be appreciated, however, that the processing of the phase error messages occurs in the DSP on said discrete values.

The method uses a threshold value, for example a signed threshold value ± *Thsd*, which may be programmable. Digital values of the phase error message *Err2* output by the ΣΔ noise cancellator 113 are compared with said threshold value at the pace of the operation clock signal *Clk.*

As shown illustrated by FIG.4, the phase error signal *Err2* is a signal with the constant frequency of the clock signal *Clk* which is used for the DPLL timing. The magnitude of the phase error signal *Err2* is variable and this variation is proportional to the phase error between the reference clock signal 201 and the divided clock signal 401 applied on either input of the TDC 105.

A counter 114 (as shown in FIG.2) is implemented in the DSP for counting the number of periods of the clock signal *Clk* during which the absolute value of the phase error signal *Err2* stays below the threshold value. When counter 114 reaches its maximum counting value K, a change of the logic state of the output signal 901 of the lock detector 109 is caused by the DSP, so that output signal 901 is set to indicate that the phase lock condition is met.

In order to illustrate the phase lock detection strategy according to a proposed embodiment, the timing diagrams of FIG.4 are divided in six phases of operation. It is recalled that, in line with the convention mentioned in the beginning of the present description, instant values of the phase error signal *Err2* must be considered on the rising edges of pulses of the clock signal *Clk*.

In the shown embodiment, the maximum counting value K counter 114 is equal to 5 (K=5). For the purpose of illustration, the current counting value of the counter 114 is indicated by a figure (from 0 to 5) in the corresponding pulse of the clock signal *Clk* as shown in FIG.4.

In a first phase 41 starting at instant t0 and ending at instant t1, the phase error signal *Err2* is above the threshold value. This means that the DPLL is unlocked. Thus, the counter value remains 0, assuming that the counter has been previously set to zero. In the shown example, the duration of this phase 41 corresponds to two pulses of the clock signal *Clk*.

At instant t1, the DPLL locks and this starts a second phase 42 followed by a third phase 43 during which the DPLL remains phase locked. The counting is started at instant t1, and the maximum counting value K=5 of counter 114 is reached at instant t2, which corresponds to the end of phase 42 and the start of phase 43. At that instant, the DSP causes the activation of the lock detect signal 901, for instance at a logic high state as shown in FIG.4.

In the shown example, the lock state of the DPLL lasts for only two periods of the clock signal *Clk* since, at instant t3, the phase error signal *Err2* goes above the threshold value again. Thus, the lock detect signal 901 is reset to its logic inactive state, and the counter 114 is reset to zero, so that a further phase of operation 44 is started wherein the DPLL is unlocked.

At instant t4, the phase lock condition is met again but at instant t5 the locking is lost before the counter 114 has reached its maximum value K=5. Accordingly, the counting is operated only during the operation phase 45 starting at t4 and ending at t5 which is less than K times the clock period, so that the lock detect signal 901 is not set. At instant t5 another operation phase 46 is started wherein the counter value is zero. This illustrates that the counter may be reset to zero before reaching its maximum value K and thus without the lock detect signal being activated.

In some embodiments, the number K and/or the threshold value Thsd are programmable, which allows adapting the detection scheme to any particular application, and possibly to provide a dynamic adaptation process of the phase lock detection scheme.

Not restricted to a count-up counter. In same case, a count-down counter can be used instead. Thus, Lock detection will occur when the counter reaches 0 and the counter will be pre-loaded to K when the absolute value of Err2 is above the threshold value.

It will be appreciated that this counting mechanism as described above allows reducing false phase lock detections. However, the higher the maximum counting value K of counter 114, the longer it takes to confirm the lock state of the DPLL to the application. Thus, the maximum counting value of counter 114 must be determined as a trade-off between accuracy and speed of the phase lock detection scheme. The number considered here, namely K=5, is convenient for illustration purpose but is only an example.

It should be understood, more generally, that the invention is not intended to be limited by specific numbers described herein.

Indeed, while there has been illustrated and described what are presently considered to be the preferred embodiments of the present invention, it will be understood by those skilled in the art that various other modifications may be made, and equivalents may be substituted, without departing from the true scope of the present invention. Additionally, many modifications may be made to adapt a particular situation to the teachings of the present invention without departing from the central inventive concept described herein. Furthermore, an embodiment of the present invention may not include all of the features described above.

The present invention can be implemented in hardware, software, or a combination of hardware and software. Any processor, controller, or other apparatus adapted for carrying out the functionality described herein is suitable. A typical combination of hardware and software could include a DSP with an application computer program that, when loaded and executed, carries out the functionality described herein.

It shall be noted that signals are described as "activated" or "deactivated" rather than "active high" or "active low", to indicate that this invention does not have any preference for active high or active low logic.

Also, expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

To summarize, it is intended that the present invention be not limited to the particular embodiments disclosed, but that the invention include all embodiments falling within the scope of the appended claims.

**Claims**

1. A fractional Digital Phase-Locked Loop, DPLL, circuit (1) comprising:

    - an Oscillator (100) adapted to generate a synthesized clock signal (601),
    - a fractional frequency divider (103), adapted to divide the synthesized clock signal by a division ratio having an integer part and a fractional part,
    - a Time-to-Digital Converter (105), TDC, having:

        ■ a first input adapted to receive a reference clock signal (201),

■ a second input adapted to receive the divided synthesized clock signal (401) from the fractional frequency divider,
■ an output adapted to generate a first phase error message (*Err1*) representative of a phase error between the reference clock signal and the divided synthesized clock signal,

- a digital modulation module (110) adapted to generate a modulation signal and to modulate the fractional part of the division ratio using said modulation signal,
- a digital modulation noise cancellation module (113) having:

■ a first input adapted to receive the first phase error message from the TDC,
■ a second input adapted to receive the modulation noise from the modulation module,
■ an output adapted to generate a second digital phase error message (*Err2*) corresponding to the first phase error message in which a modulation noise associated to the modulation of the fractional part of the division ratio has been cancelled,

- a digital phase lock detector module (109) having an input adapted to receive the second phase error signal and to generate a lock detect signal (901) indicating a lock state of the DPLL, with respect to the second phase error message.

2. The fractional DPLL circuit of claim 1, wherein the phase lock detector module is adapted to activate the lock detect signal when a given number of successive values of the second phase error messages keep below a given threshold (Thsd).

3. The fractional DPLL circuit of claim 2, wherein the given number and/or the given threshold are programmable.

4. The fractional DPLL circuit of any one of claims 1 to 3, comprising a Digital Signal Processor (20), DSP, and wherein at least some of the digital modulation module, the digital noise cancellation module and the digital phase lock detector module are embedded in the DSP.

5. The fractional DPLL circuit of any one of claims 1 to 4, wherein the division ratio of the frequency divider is programmable.

6. The fractional DPLL circuit of any one of claims 1 to 5, wherein the digital modulation module is a $\Sigma\Delta$ modulator.

7. The fractional DPLL circuit of any one of claims 1 to 6, wherein the frequency of the modulation signal is programmable.

8. A method of detecting a phase lock state of a fractional Digital Phase-Locked Loop, DPLL, circuit (1) comprising:

- a Oscillator (100), adapted to generate a synthesized clock signal (601);
- a fractional frequency divider (103), adapted to divide the synthesized clock signal by a division ratio having an integer part and a fractional part,
- a Time-to-Digital Converter (105), TDC, having:

■ a first input adapted to receive a reference clock signal (201),
■ a second input adapted to receive the divided synthesized clock signal (401) from the fractional frequency divider,
■ an output adapted to generate a first phase error message (*Err1*) representative of a phase error between the reference clock signal and the divided synthesized clock signal,

- a digital modulation module (110) adapted to generate a modulation signal and to modulate the fractional part of the division ratio using said modulation signal,
- a digital modulation noise cancellation module (113) having:

■ a first input adapted to receive the first phase error message from the TDC,
■ a second input adapted to receive the modulation noise from the modulation module,
■ an output adapted to generate a second digital phase error message (*Err2*) corresponding to the first phase error message in which a modulation noise associated to the modulation of the fractional part of the division ratio has been cancelled,

wherein the method comprises generating a lock detect signal (901) indicating the lock state of the DPLL, with respect to the second phase error message.

9. The method of claim 8, comprising activating the lock detect signal when a given number of successive values of the second phase error messages keep below a given threshold.

10. The method of claim 9, wherein the given number and/or the given threshold are programmable.

11. A frequency synthesizer integrated circuit comprising a fractional Digital Phase-Locked Loop, DPLL, circuit according to any one of claims 1 to 7.

12. A computer program product comprising one or more stored sequences of instructions that are accessible to a processor and which, when executed by the processor, cause the processor to perform the steps of any of claims 6 to 10.

Reference Clock

Divided Clock

Capture Window

To

**FIG.1
(Prior Art)**

**FIG.2**

**FIG.3**

**FIG.4**

Europäisches
Patentamt

European
Patent Office

Office européen
des brevets

# EUROPEAN SEARCH REPORT

Application Number

EP 13 30 5655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/234269 A1 (YU QICHENG [US]) 29 September 2011 (2011-09-29) * paragraph [0033] - paragraph [0038]; figure 6 * ----- | 1-12 | INV. H03L7/197 |
| A | US 2012/007643 A1 (JIAN HENG-YU [US] ET AL) 12 January 2012 (2012-01-12) * abstract; figure 9 * ----- | 1-12 | |
| A | US 2009/231050 A1 (LIN CHIA-LIANG [US]) 17 September 2009 (2009-09-17) * abstract; figure 2b * ----- | 1-12 | |
| A | US 2010/039182 A1 (GALTON IAN [US] ET AL) 18 February 2010 (2010-02-18) * abstract; figure 7 * ----- | 1-12 | |

TECHNICAL FIELDS
SEARCHED      (IPC)

H03L

The present search report has been drawn up for all claims

| Place of search | Date of completion of the search | Examiner |
|---|---|---|
| The Hague | 23 October 2013 | Beasley-Suffolk, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 30 5655

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2013

| Patent document cited in search report | | | Publication date | Patent family member(s) | | Publication date |
|---|---|---|---|---|---|---|
| US 2011234269 | A1 | | 29-09-2011 | NONE | | |
| US 2012007643 | A1 | | 12-01-2012 | CN | 103081362 A | 01-05-2013 |
| | | | | EP | 2591554 A1 | 15-05-2013 |
| | | | | TW | 201214979 A | 01-04-2012 |
| | | | | US | 2012007643 A1 | 12-01-2012 |
| | | | | WO | 2012006323 A1 | 12-01-2012 |
| US 2009231050 | A1 | | 17-09-2009 | NONE | | |
| US 2010039182 | A1 | | 18-02-2010 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8248106 B